(19) Europäisches Patentamt

European Patent Office

Office européen des brevets

(11) Numéro de publication: **0 239 443 B1**

(12) **FASCICULE DE BREVET EUROPEEN**

(45) Date de publication de fascicule du brevet: **21.07.93** (51) Int. Cl.⁵: **G01J 1/04**

(21) Numéro de dépôt: **87400398.1**

(22) Date de dépôt: **24.02.87**

(54) **Capteur d'éclairement perfectionné.**

(30) Priorité: **28.03.86 FR 8604526**

(43) Date de publication de la demande:
**30.09.87 Bulletin 87/40**

(45) Mention de la délivrance du brevet:
**21.07.93 Bulletin 93/29**

(84) Etats contractants désignés:
**BE DE GB**

(56) Documents cités:
**CH-A- 408 211**
**DE-A- 1 028 357**
**DE-B- 1 240 295**
**FR-A- 1 355 752**
**US-A- 3 880 528**

(73) Titulaire: **SEXTANT AVIONIOUE**
**Immeuble le Galilée Parc Tertiaire de Meudon 5/7, rue Jeanne Braconnier**
**F-92366 Meudon la Foret Cédex(FR)**

(72) Inventeur: **Pilot, Alain**
**27, rue Renoir**
**F-78960 Voisins Le Bretonneux(FR)**
Inventeur: **Grasset, Marcel**
**19, rue Jean-Mermoz**
**F-78390 Bois D'Arcy(FR)**

(74) Mandataire: **Marquer, Francis et al**
**Cabinet Moutard 35, Avenue Victor Hugo**
**F-78960 Voisins le Bretonneux (FR)**

EP 0 239 443 B1

**Description**

La présente invention concerne un capteur d'éclairement apte à fournir une information électrique proportionnelle à un éclairement et ce, dans une large gamme d'éclairement, par exemple de l'ordre de 0 à 200.000 lux.

D'une manière générale, on sait que les dispositifs servant à la mesure de l'éclairement font habituellement intervenir des capteurs consistant ou utilisant des composants optoélectroniques tels que, par exemple des photodiodes ou des phototransistors.

Or il s'avère que selon la technologie actuellement utilisée pour leur réalisation, ces composants présentent un certain nombre d'inconvénients.

- Un premier de ces inconvénients réside dans la non-linéarité du signal fourni par le capteur en fonction de l'éclairement, non-linéarité qui nécessite l'utilisation en aval du capteur d'un circuit électronique de linéarisation relativement complexe et coûteux.
- Un second inconvénient provient du fait que lors d'une augmentation de l'éclairement, le composant photoélectronique se sature très rapidement, ce qui limite la gamme d'éclairement dans laquelle on peut effectuer la mesure.
- Un troisième inconvénient consiste en ce que l'angle d'ouverture du composant photoélectronique est très faible, ce qui conduit à utiliser pour étendre cet angle, des montages optiques grand angulaire, voire même des circuits à guides optiques.

Pour tenter de résoudre tout ou partie de ces problèmes on a proposé des solutions faisant intervenir des montages optiques faisant intervenir des éléments diffusants tels que, par exemple ceux qui se trouvent décrits dans les brevets US-A-3 880 528, FR-A-1 355 752 ou DE-A-1 028 357. Toutefois, ces montages sont relativement complexes, coûteux et peu industrialisables.

L'invention a donc plus particulièrement pour but la réalisation d'un capteur de conception très simple et peu coûteuse qui supprime ces inconvénients.

Pour parvenir à ces résultats, l'invention propose un capteur d'éclairement apte à fournir une information électrique proportionnelle à un éclairement, ce capteur comprenant une structure tubulaire obturée d'un côté par un élément translucide destiné à être exposé à la lumière dont on veut mesurer l'éclairement, et un composant optoélectronique positionné à l'intérieur de ladite structure avec sa fenêtre transparente disposée au droit dudit élément, et des moyens de solidarisation dudit composant avec ladite structure.

Selon l'invention, ce dispositif est caractérisé en ce que :

- la structure tubulaire consiste en un fourreau réalisé en une matière translucide présentant des propriétés diffusantes, ce fourreau étant destiné à recevoir le composant optoélectronique et présentant un fond qui constitue ledit élément translucide, et
- les moyens de solidarisation consistent en une matière plastique transparente dont l'indice de réfraction est voisin de celui de la fenêtre transparente et dans laquelle ledit composant optoélectronique se trouve enrobé, cette matière remplissant au moins partiellement le volume libre compris entre le composant et ses éléments de connexion et le fourreau, de manière à assurer à la fois la solidarisation du composant optoélectronique avec le fourreau et la continuité optique entre le fond du fourreau et la fenêtre de l'élément photoélectronique.

Dans un tel capteur, le fond joue le rôle d'un interface optique permettant, grâce aux propriétés diffusantes de la matière translucide, de transformer la lumière incidente en une infinité de sources lumùineuses se trouvant dans le champ optique du composant optoélectronique. On s'affranchit ainsi des problèmes relatifs à l'angle d'ouverture du composant optoélectronique.

Ainsi, dans le cas d'un fond présentant une face extérieure plane, il devient possible de mesurer des éclairements produits par des rayons lumineux présentant des angles d'incidence proches de 90°.

Ce résultat peut être considérablement amélioré en utilisant un fond dont la surface extérieure présente une forme convexe, par exemple une forme conique ou une forme sphérique.

Par ailleurs, en utilisant un fond en forme de ménisque, avec une face extérieure convexe et une face intérieure concave, on obtient avantageusement une concentration de la lumière diffusée sur la face sensible du composant photoélectronique.

En outre, il est possible d'améliorer les performances du capteur en effectuant un piégeage du rayonnement lumineux diffusé par le fond. A cet effet, il est possible de revêtir la paroi intérieure du fourreau, au moins dans une zone comprise entre le fond et le composant photoélectronique, d'un élément optiquement réfléchissant.

Il convient de noter que l'épaisseur de matière au niveau du fond détermine l'atténuation des rayonnements incidents par rapport au rayonnement diffusé. Or, cette atténuation doit être prévue de manière à éviter la saturation du composant photoélectronique et à faire en sorte que celui-ci fonctionne dans une plage où sa réponse varie linéairement en fonction de l'éclairement.

C'est la raison pour laquelle l'invention prévoit également un fourreau dans lequel le fond présente, à l'origine, une épaisseur relativement importante, cette épaisseur pouvant ensuite être ajustée et conformée par l'utilisateur selon le type d'application recherché, par usinage.

Des modes d'exécution de l'invention seront décrits ci-après à titre d'exemples non limitatifs, avec référence aux dessins annexés dans lesquels :

La figure 1 représente schématiquement un montage classique d'un phototransistor ;

Les figures 2 et 3 sont deux représentations graphiques montrant respectivement la courbe de réponse du phototransistor en fonction de l'éclairement et la courbe de variation de l'atténuation en fonction de l'angle d'incidence des rayons lumineux ;

La figure 4 erst une coupe axiale schématique d'un capteur selon l'invention ;

Les figures 5 et 6 sont des représentations graphiques analogues à celles représentées sur les figures 2 et 3 qui illustrent les performances du capteur représenté figure 4 ; et

Les figures 7 et 8 représentent schématiquement, en coupe axiale, des variantes d'exécution du capteur selon l'invention.

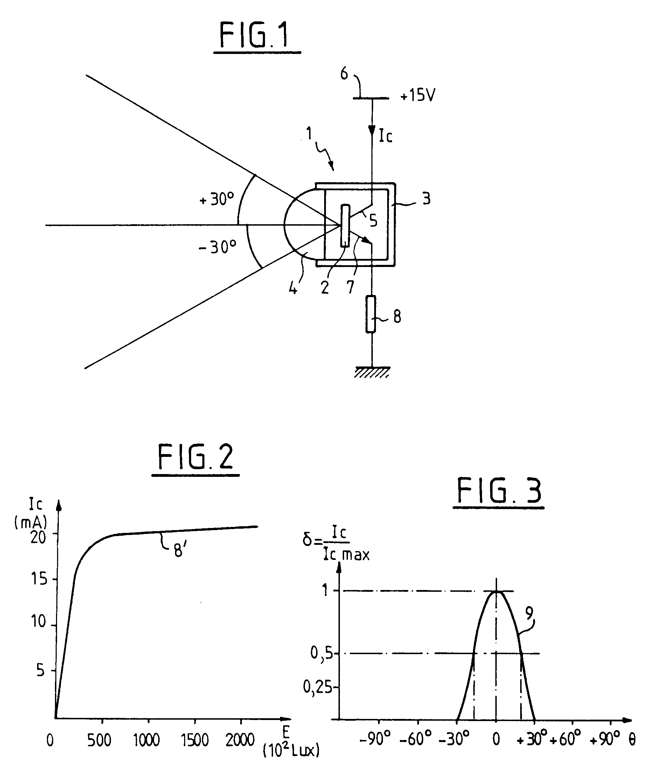

Tel que représenté sur la figure 1, le phototransistor 1 se compose d'un élément semi-conducteur 2 logé dans un boîtier 3 présentant une fenêtre 4 située au droit de la face de cet élément semi-conducteur sensible aux rayons lumineux. Cette fenêtre 4 est habituellement réalisée à l'aide d'une pastille de verre présentant une face extérieure convexe.

L'élément semi-conducteur présente, par ailleurs, une électrode collectrice 5 qui, dans l'exemple représenté, est connectée à une source de tension 6 positive, par exemple de 15 V et une électrode émettrice 7 reliée à la masse par l'intermédiaire d'une résistance 8, par exemple de 710 Ω.

La figure 2 représente la courbe de variation $8'$ du courant Ic traversant le phototransistor pour un éclairement variant entre 0 et 200.000 lux. On constate sur cette figure qu'en partant d'un éclairement nul, le courant Ic croît rapidement, d'une façon linéaire jusqu'à ce que l'éclairement atteigne une valeur de l'ordre de 25.000 lux pour une intensité d'environ 15 mA. A partir de cette valeur, la courbe $8'$ s'incurve puis l'intensité se stabilise à partir d'un éclairement de 210.000 lux à une valeur constante, de l'ordre de 20 mA. Cette stabilisation est due au phénomène de saturation du phototransistor 1. Il est clair qu'en raison de cette saturation, le phototransistor 1 ne peut être utilisé directement que pour des plages d'éclairement limitées, en l'occurrence de 0 à 25.000 lux.

La courbe 9 de la figure 3 montre en outre que l'angle d'ouverture σ du capteur est très faible (± 18°) par rapport à la normale pour une atténuation $\delta = \frac{Ic}{I}_{max}$ du courant Ic de 50 %.

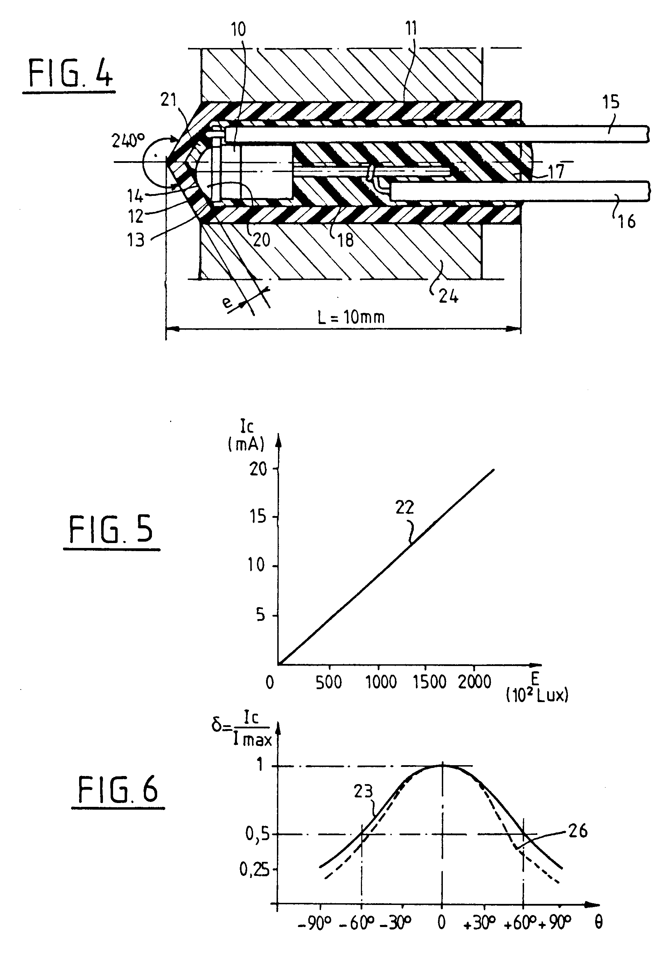

Le capteur représenté sur la figure 4 permet de supprimer à la fois ces trois inconvénients.

Il fait intervenir un phototransistor 10 du type de celui représenté sur la figure 1, monté dans un fourreau de section cylindrique dont le fond 12 d'épaisseur e possède une surface convexe 13 de forme conique et une face intérieure concave 14 également conique. Bien entendu, les dimensions de ce fourreau 11 dépendent de celles du phototransistor utilisé. Ainsi, dans le cas d'un phototransistor courant, par exemple du type BPX 31 commercialisé par la Société RTC, le diamètre extérieur du fourreau peut être de l'ordre de 3,4 mm tandis que sa longueur L peut être inférieure à 10 mm. Comme précédemment mentionné, ce fourreau 11 doit être réalisé en une matière translucide présentant une bonne aptitude à la diffusion des rayons lumineux. Sa rigidité doit être suffisante pour assurer une bonne protection mécanique du capteur. En outre, sa dureté et son inertie vis-à-vis de la corrosion doivent être suffisantes pour qu'il puisse résister sans modification de ses propriétés optiques aux agents utilisés pour assurer le nettoyage de la face extérieure du fond qui constitue en fait la zone réceptrice de lumière et doit demeurer parfaitement propre à l'instar de tous les composants optiques.

D'excellents résultats ont été obtenus à l'aide d'une matière plastique translucide blanche commercialisée par la Société Du Pont sous le nom de "Delrin".

Dans ce capteur, la liaison électrique entre le phototransistor 10 et le circuit électronique de mesure est assurée par des fils conducteurs 15, 16, respectivement connectés à l'émetteur et au collecteur du phototransistor 10, ces fils 15, 16 s'étendant axialement dans le fourreau 11 puis ressortant par son ouverture 17, à l'opposé du fond.

Le positionnement du phototransistor 10 ainsi que des portions des fils conducteurs 15, 16 situées à l'intérieur du fourreau est réalisé par enrobage, à l'aide d'une matière plastique transparente 18, par exemple un élastomère, dont l'indice de réfraction est voisin de celui de la pastille de verre 20 constituant la fenêtre du phototransistor 10.

Le rôle de cet enrobage ne se limite pas à sa seule fonction mécanique.

En effet, il permet également d'assurer une étanchéité parfaite du capteur. En outre, la partie de cet enrobage qui remplit le volume 21 compris entre la face sensible du phototransistor 10 et le fond 12, sert à assurer une continuité optique du rayonnement optique diffusé par le fond 12. Elle évite en particulier la discontinuité dont seraient affectés ces rayonnements au niveau de la surface de la pastille 20 du phototransistor 10 si le volume présentait un indice de réfraction différent, (ce qui serait par exemple le cas si ce volume était vide).

Dans l'exemple représenté sur la figure 4, la conicité de la face extérieure 13 du fond 12 a été prévue sensiblement égale à 240° de manière à étendre le plus possible l'angle d'ouverture du capteur.

Les performances du capteur précédemment décrit sont illustrées sur les figures 5 et 6.

Ainsi, le graphique de la figure 5 montre que le courant Ic (courbe 22) suit une loi linéaire en fonction de l'éclairement E, même pour des valeurs supérieures à 200.000 lux.

Par ailleurs, comme on peut le voir sur la figure 6, l'angle d'ouverture est porté à ± 60° pour une atténuation de 50 % du courant Ic, tandis qu'un angle de ± 90° reste exploitable, l'atténuation (courbe 23) dans ce cas étant de l'ordre de 75 %.

Il convient de noter que, grâce à la forme cylindrique du fourreau 11, le montage du capteur se trouve considérablement simplifié. Il peut par exemple être simplement engagé, comme représenté dans un perçage de diamètre correspondant d'une structure de support 24.

Bien entendu, l'invention ne se limite pas à la forme du fourreau précédemment décrite.

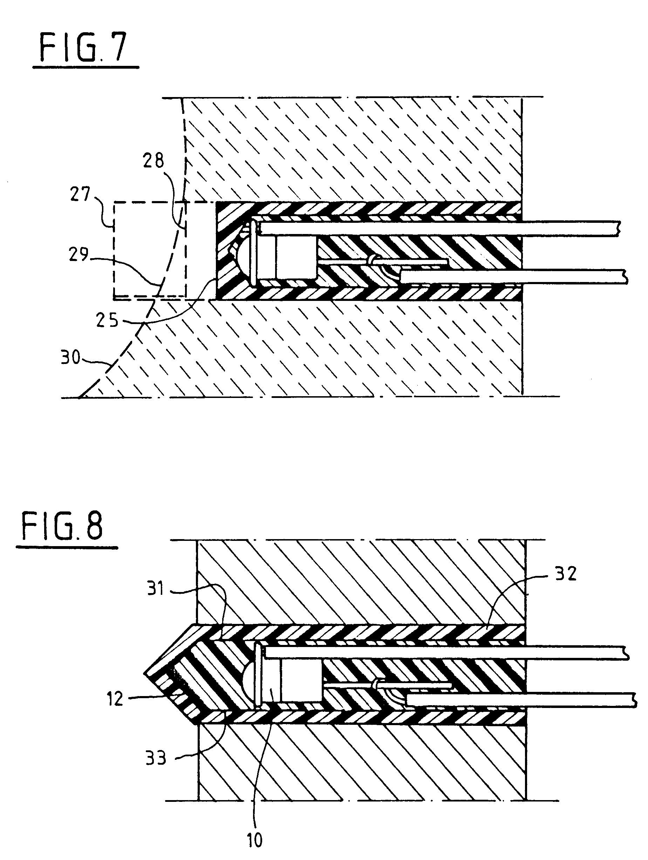

Ainsi, la face extérieure du fourreau pourrait être plane, comme représenté sur la figure 7 en traits pleins (référence 25). Il s'avère en effet que cette solution, légèrement moins performante, dans le cas d'angles d'incidence élevés, demeure cependant intéressante, comme il ressort de la courbe 26 représentée en traits interrompus sur la figure 6.

Par ailleurs, le fourreau peut présenter à l'origine un fond relativement épais (de l'ordre de plusieurs fois l'épaisseur du fourreau) que l'utilisateur pourra lui-même conformer selon le type d'application. La figure 7 indique en points interrompus (référence 27) un tel fond.

En particulier, l'opérateur pourra lui-même ajuster l'épaisseur du fond, pour obtenir l'atténuation recherchée, par exemple en le ramenant à l'épaisseur indiquée par le trait interrompu 28.

Il pourra également rectifier le fond pour obtenir une continuité de forme avec la face antérieure du support et éviter ainsi que le capteur ne vienne pas en saillie ou en retrait par rapport à celle-ci.

Ainsi, sur la figure 7, le trait interrompu de forme courbe 29 illustre une conformation du fond appropriée à la courbure de la face antérieure 30 du support (également en traits interrompus).

Dans l'exemple représenté sur la figure 8, la portion 31 de surface cylindrique intérieure du fourreau 32 comprise entre le phototransistor 10 et le fond 12 est recouverte d'un revêtement réfléchissant 33 servant à renvoyer une fraction du rayonnement lumineux diffusé par le fond 12 sur la surface sensible du phototransistor 10.

Il s'avère donc que le capteur selon l'invention est particulièrement avantageux notamment grâce à :

- sa possibilité d'utilisation dans les conditions d'environnement les plus sévères,
- son faible encombrement et sa conformation,
- sa simplicité de réalisation et de mise en oeuvre,
- l'adaptation facile de la sensibilité du capteur à la dynamique d'éclairement souhaitée,
- la possibilité de modifier la forme de l'extrémité du capteur avec cependant une légère réduction de l'angle d'ouverture qui demeure toutefois dans des limites acceptables pour l'application.

Ce capteur peut, par conséquent, être aussi bien utilisé dans des secteurs à haute technologie que dans des secteurs grand public.

## Revendications

1. Capteur d'éclairement apte à fournir une information électrique proportionnelle à un éclairement, ce capteur comprenant une structure tubulaire obturée d'un côté par un élément translucide destiné à être exposé à la lumière dont on veut mesurer l'éclairement, et un composant optoélectronique (10) positionné à l'intérieur de ladite structure avec sa fenêtre transparente (20) disposée au droit dudit élément, et des moyens de solidarisation dudit composant (10) avec ladite structure, caractérisé en ce que :
   - la structure tubulaire consiste en un fourreau (11) réalisé en une matière translucide présentant des propriétés diffusantes, ce fourreau (11) étant destiné à recevoir le composant optoélectronique (10) et présentant un fond (12) qui constitue ledit élément translucide, et
   - les moyens de solidarisation consistent en une matière plastique transparente (17) dont l'indice de réfraction est voisin de celui de la fenêtre transparente (20) et dans laquelle ledit composant optoélectronique se trouve enrobé, cette matière (17) remplissant au moins partiellement le volume libre compris entre le composant (10) et ses éléments de connexion et le fourreau, de manière à assurer à la fois la solidarisation du composant optoélectronique (10) avec le fourreau (11) et la continuité optique entre le fond (12) du fourreau (11) et la fenêtre (20) de l'élément optoélectronique (10).

**2.** Capteur selon la revendication 1, caractérisé en ce que ledit fond (12) présente une surface extérieure (13) plane ou convexe.

**3.** Capteur selon l'une des revendications précédentes, caractérisé en ce que ledit fond (12) présente une surface extérieure (13) conique ou sphérique.

**4.** Capteur selon l'une des revendications précécdentes, caractérisé en ce que ledit fond (12) présente une surface intérieure (14) concave.

**5.** Capteur selon l'une des revendications précédentes, caractérisé en ce que ledit fond (12) est en forme de ménisque, avec sa face extérieure convexe (13) et sa face intérieure concave.

**6.** Capteur selon l'une des revendications précédentes, caractérisé en ce que l'épaisseur (e) dudit fond (12) est ajustable.

**7.** Capteur selon l'une des revendications précédentes, caractérisé en ce que ledit fond (12) présente une épaisseur importante de l'ordre de plusieurs fois l'épaisseur du fourreau (11), de manière à pouvoir être conformé par l'utilisateur par découpe et/ou par usinage.

**8.** Capteur selon l'une des revendications précédentes, caractérisé en ce qu'il comprend des moyens de piégeage du rayonnement lumineux diffusé par le fond (12).

**9.** Capteur selon la revendication 8, caractérisé en ce que les susdits moyens de piégeage consistent en au moins un élément optiquement réfléchissant (33) disposé dans la zone du fourreau (11) comprise entre le composant optoélectronique (10) et ledit fond (12).

**10.** Capteur selon la revendication 1, caractérisé en ce que la susdite matière plastique (17) est un élastomère.

**11.** Capteur selon l'une des revendications précédentes, caractérisé en ce que la matière constituant le fourreau (11) est une matière plastique translucide.

**12.** Capteur selon la revendication 1, caractérisé en ce que ladite matière plastique est du "Delrin" blanc.

**13.** Capteur selon l'une des revendications précédentes, caractérisé en ce que le susdit composant optoélectronique est un phototransistor.

**Claims**

**1.** An illumination sensor adapted for delivering electric information proportional to an illumination, said sensor comprising a tubular structure closed at one side by a translucent element intended to be exposed to the light the illumination of which is to be measured, and an optoelectronic component (10) placed inside said structure, with its transparent window (20) placed in line with said element, and means for joining said component (10) and said structure together, characterized in that

- the tubular structure consists of a sleeve (11) made from a translucent material having diffusing properties, this sleeve (11) being intended to receive the optoelectronic component (10) and having a bottom (12) which forms said translucent element, and

- in that said joining means are made from a transparent plastic material (17) whose index of refraction is close to that of the transparent window (20) and which covers said optoelectronic component, said material (17) filling at least partially the free space between the component (10) and its connection elements and the sleeve, so as to provide both interlocking of the optoelectronic component (10) with the sleeve (11) and optical continuity between the bottom (12) of the sleeve (11) and the window (20) of the optoelectronic element (10).

**2.** The sensor as claimed in claim 1, characterized in that said bottom (12) has an external flat or convex surface (13).

**3.** The sensor as claimed in one of the preceding claims, characterized in that said bottom (12) has an external conical or spherical surface (13).

**4.** The sensor as claimed in one of the preceding claims,

characterized in that said bottom (12) has an inner concave surface (14).

5. The sensor as claimed in one of the preceding claims,
characterized in that said bottom (12) is in the form of a meniscus, with its external face (13) convex and its internal face concave.

6. The sensor as claimed in one of the preceding claims,
characterized in that the thickness (e) of said bottom (12) is adjustable.

7. The sensor as claimed in one of the preceding claims,
characterized in that said bottom (12) has a great thickness of the order of several times the thickness of the sleeve (11) so as to be able to be shaped by the user by cutting and/or by machining.

8. The sensor as claimed in one of the preceding claims, characterized in that it comprises means for trapping the light radiation diffused by the bottom (12).

9. The sensor as claimed in claim 8,
characterized in that said trapping means consist of at least one optically reflecting element (33) disposed in the zone of the sleeve (11) situated between the optoelectronic component (10) and said bottom (12).

10. The sensor as claimed in claim 1,
characterized in that said plastic material (17) is an elastomer.

11. The sensor as claimed in one of the preceding claims,
characterized in that the material forming the sleeve (11) is a translucent plastic material.

12. The sensor as claimed in claim 1,
characterized in that said plastic material is white "Delrin".

13. The sensor as claimed in one of the preceding claims,
characterized in that said optoelectronic component is a phototransistor.

**Patentansprüche**

1. Beleuchtungsstärke-Sonde, die eine elektrische Information proportional zu einer Beleuchtungsstärke liefern kann, wobei diese Sonde eine rohrförmige Struktur, die auf einer Seite von einem lichtdurchlässigen Element verschlossen wird, das dem Licht ausgesetzt wird, dessen Beleuchtungsstärke gemessen werden soll, und ein opotoelektronisches Bauteil (10), das im Inneren der Struktur positioniert und dessen transparentes Fenster (20) gegenüber dem Element angeordnet ist, sowie Mittel zur festen Verbindung des Bauteils (10) mit der Struktur aufweist, dadurch gekennzeichnet, daß
- die rohrförmige Struktur aus einer Hülse (11) besteht, die aus einem lichtdurchlässigen Material hergestellt ist, das diffundierende Eigenschaften aufweist, wobei diese Hülse (11) das optoelektronische Bauteil (10) aufnimmt und einen Boden (12) aufweist, der das lichtdurchlässige Element bildet, und
- die Verbindungsmittel aus einem transparenten Kunststoffmaterial (17) bestehen, dessen Brechungsindex nahe dem des transparenten Fensters (20) ist und mit dem das optoelektronische Bauteil umhüllt ist, wobei dieses Material (17) mindestens teilweise das freie Volumen zwischen dem Bauteil (10) und seinen Anschlußmitteln und der Hülse ausfüllt, um gleichzeitig die feste Verbindung des optoelektronischen Bauteils mit der Hülse (11) und die optische Kontinuität zwischen dem Boden (12) der Hülse (11) und dem Fenster (20) des optoelektronischen Elements (10) zu sichern.

2. Sonde nach Anspruch 1, dadurch gekennzeichnet, daß der Boden (12) eine flache oder konvexe Außenoberfläche (13) aufweist.

3. Sonde nach einem der vorhergehenden Ansprüche, dadurch gekennzeichnet, daß der Boden (12) eine konische oder kugelförmige Außenoberfläche (13) aufweist.

4. Sonde nach einem der vorhergehenden Ansprüche, dadurch gekennzeichnet, daß der Boden (12) eine konkave innere Oberfläche (14) aufweist.

5. Sonde nach einem der vorhergehenden Ansprüche, dadurch gekennzeichnet, daß der Boden (12) sichelförmig ist, wobei seine Außenoberfläche konvex (13) und seine Innenoberfläche konkav ist.

6. Sonde nach einem der vorhergehenden Ansprüche, dadurch gekennzeichnet, daß die Dikke (e) des Bodens (12) einstellbar ist.

7. Sonde nach einem der vorhergehenden Ansprüche, dadurch gekennzeichnet, daß der Boden (12) eine große Dicke der Größenordnung von mehrfach der Dicke der Hülse (11) aufweist, um vom Benutzer durch Ausschnitt und/oder Bearbeitung angepaßt werden zu können.

8. Sonde nach einem der vorhergehenden Ansprüche, dadurch gekennzeichnet, daß sie Mittel zum Einfangen der vom Boden (12) diffundierten Lichtstrahlung aufweist.

9. Sonde nach Anspruch 8, dadurch gekennzeichnet, daß die Einfangmittel aus mindestens einem optisch reflektierenden Element (33) bestehen, das in dem Bereich der Hülse (11) angeordnet ist, der sich zwischen dem optoelektronischen Bauteil (10) und dem Boden (12) befindet.

10. Sonde nach Anspruch 1, dadurch gekennzeichnet, daß das Kunststoffmaterial (17) ein Elastomer ist.

11. Sonde nach einem der vorhergehenden Ansprüche, dadurch gekennzeichnet, daß das die Hülse (11) bildende Material ein lichtdurchlässiges Kunststoffmaterial ist.

12. Sonde nach Anspruch 1, dadurch gekennzeichnet, daß das Kunststoffmaterial weißes "Delrin" ist.

13. Sonde nach einem der vorhergehenden Ansprüche, dadurch gekennzeichnet, daß das optoelektronische Bauteil ein Phototransistor ist.

## FIG.1

## FIG.2

## FIG.3

$$\delta = \frac{Ic}{Ic\,max}$$

8

FIG. 4

10    11

21

240°

14
12
13

20    18    24

15

17

16

e

L = 10mm

FIG. 5

Ic
(mA)

20

15

22

10

5

0    500   1000  1500  2000    E
(10²Lux)

FIG. 6

$\delta = \frac{Ic}{I max}$

1

23

0,5

26

0,25

−90°  −60°  −30°    0    +30°  +60°  +90°    θ

## FIG.7

## FIG.8